# FASCICULE DE BREVET EUROPEEN

(11) **EP 0 448 474 B1**
(45) Date de publication et mention de la délivrance du brevet: **14.06.1995**
(21) Numéro de dépôt: 91400774.5
(22) Date de dépôt: 21.03.1991
(51) Int. Cl.: H01J 37/20, H01J 37/317, H01L 21/00

(54) **Dispositif pour rendre homogène l'implantation d'ions sur la surface d'échantillons plans**
Verfahren zur Homogenisierung der Ionenimplantierung auf der Oberfläche ebener Proben
Device for homogenizing the ion implantation on the surface of plane substrates

(30) Priorité: 23.03.1990 FR 9003740
(43) Date de publication de la demande: 25.09.1991
(73) Titulaire: COMMISSARIAT A L'ENERGIE ATOMIQUE, 75015 Paris (FR)
(72) Inventeur: Lamure, Jean-Michel, F-38420 Saint Jean Le Vieux (FR); Michaud, Jean François, F-73800 Montmelian (FR)
(74) Mandataire: Poulin, Gérard

(56) Documents cités:
- GB-A- 2 191 335
- PATENT ABSTRACTS OF JAPAN vol. 9, no. 193 (E-334)(1916) 09 août 1985 & JP-A-60 59646
- PATENT ABSTRACTS OF JAPAN vol. 13, no. 571 (E-862)(3919) 18 décembre 1989 & JP-A-1 238 747
- PATENT ABSTRACTS OF JAPAN vol. 11, no. 367 (E-561)(2814) 28 novembre 1987 & JP-A-62 139241

## Description

La présente invention a pour objet un dispositif pour rendre homogène l'implantation d'ions sur la surface d'échantillons plans. Elle s'applique notamment dans le domaine de la microélectronique pour l'isolation d'une couche superficielle d'une plaquette en matériau semiconducteur.

Les circuits intégrés sont généralement réalisés à partir de plaquettes semiconductrices à la surface desquelles, par des opérations de gravure, dépôt, dopage, sont créées les zones actives des circuits, les interconnexions et les isolations nécessaires.

Pour certaines applications, une partie superficielle des plaquettes semiconductrices doit être isolée sur une certaine épaisseur du reste du substrat.

Pour une plaquette en silicium, cette couche isolante peut être réalisée par implantation d'ions d'oxygène (O⁺) à travers la surface de la plaquette suivie d'un recuit à haute température. La couche isolante est donc en oxyde de silicium.

L'uniformité de la dose d'ions O⁺ reçue par la surface de la plaquette semiconductrice constitue un des critères principaux caractérisant la qualité du produit obtenu.

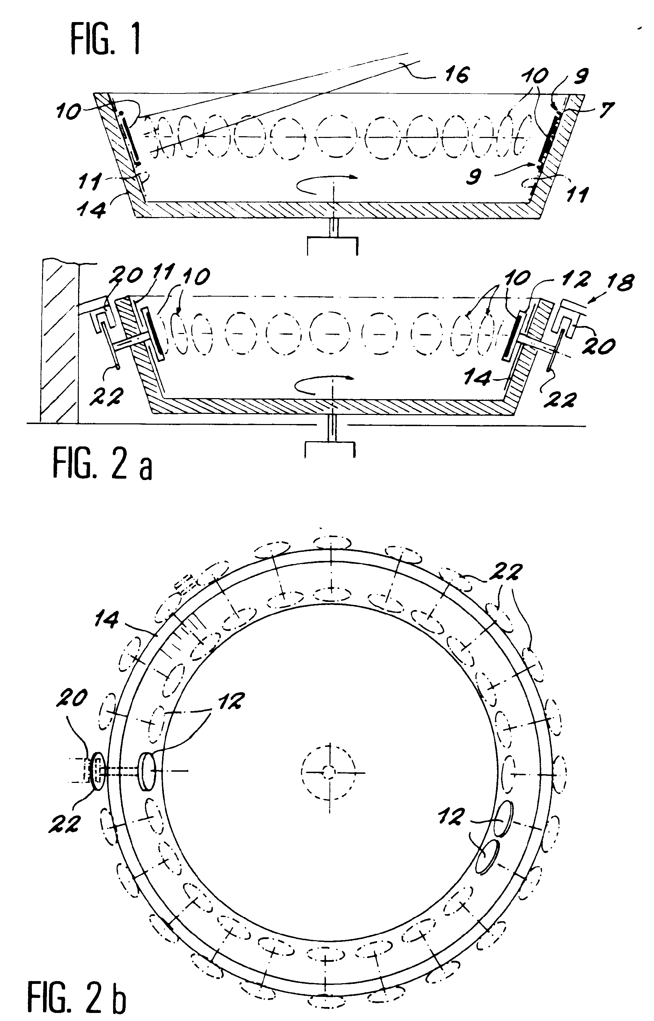

La Société américaine EATON commercialise, sous la référence NV200, un dispositif implanteur d'ions qui permet de traiter 20 à 25 plaquettes dans le même temps. Un tel dispositif connu est représenté sur la figure 1.

Les plaquettes semiconductrices 10 sont maintenues par des pions 9 par exemple en Quartz sur une couche protectrice de silicium 11 revêtant sur la face interne 7 d'un tambour ou élément rotatif 14 dont la vitesse de rotation peut aller de 100 à 1000 tr/mn.

Les plaquettes 10 défilent devant un faisceau 16 d'ions O⁺ de section elliptique et dont la grande dimension est supérieure au diamètre des plaquettes 10.

L'angle d'incidence du faisceau 16 sur les plaquettes ainsi que l'orientation de celles-ci sont choisis de manière à ce que le trajet des ions implantés dans le cristal de silicium ne corresponde pas à des trajets de canalisation (channeling). En effet, cette correspondance donnerait lieu à des variations importantes de profondeur d'implantation.

De manière connue, pour améliorer l'implantation des ions effectuée par un dispositif du type de celui représenté sur la figure 1, la section du faisceau est réduite et ce dernier est soumis à un balayage vertical lors de la rotation du tambour.

Dans ce cas, le résultat obtenu est très bon puisque les variations de dose d'implantation sont inférieures à ± 1 %. Malheureusement, la méthode qui consiste à balayer un faisceau d'ions de section réduite comporte de nombreux inconvénients :
a) l'amplitude du balayage doit être telle que le faisceau d'ions sorte complètement de la plaquette pour que la dose reste uniforme sur toute la surface. Cela entraîne des temps morts (pendant lesquels le faisceau est hors de la plaquette) et une perte importante d'ions. On compense généralement ces phénomènes par l'application d'un faisceau plus intense qui entraîne un échauffement préjudiciable à la qualité du matériau semiconducteur et des risques de pollution supplémentaires.
b) Le balayage est créé par la variation d'un courant traversant un électro-aimant. L'intensité de ce courant, avoisinant les 100 A, ne permet qu'une faible vitesse de balayage (correspondant à environ 1 aller/retour en 5 secondes) entraînant d'importantes différences de température entre les différents points des plaquettes. Pour compenser ces échauffements locaux, on fournit un chauffage additionnel pendant l'implantation, cependant on constate encore la création de défauts dans le matériau semiconducteur.
c) L'utilisation d'un faisceau d'ions focalisé et balayé et les modifications attenantes entraînent un surcoût élevé du dispositif.

On a cherché à obtenir des uniformités de dose aussi bonnes sinon meilleures que les dispositifs à balayage de faisceau d'ions focalisé sans en avoir les inconvénients. Pour cela, le document JP-A-1 239 747 préconise la mise en rotation de chaque support par rapport à un axe perpendiculaire à la surface interne du tambour. Ce mouvement se superpose à la rotation du tambour sur lui-même. Une plaquette positionnée dans un support est entraînée en rotation, ce qui permet une répartition identique de l'implantation d'ions sur toute la surface. On évite ainsi tout balayage du faisceau et les inconvénients y attenants.

La présente invention a pour objet un dispositif pour rendre homogène l'implantation d'ions sur la surface d'échantillons plans comprenant un élément rotatif et des supports d'échantillons répartis sur une face de l'élément rotatif, les supports d'échantillons étant maintenus à des premières extrémités d'axes de rotation traversant l'élément rotatif, les secondes extrémités desdits axes étant soumis à des moyens de mise en rotation des supports, caractérisé en ce que les moyens de mise en rotation des supports comprennent un moyen pour créer un champ magnétique et un disque d'entraînement sensible à un champ magnétique maintenu à chaque seconde extrémité desdits axes, une extrémité de chacun des disques d'entraînement étant plongée dans ledit champ magnétique lors de la rotation dudit élément rotatif, la rotation de l'élément rotatif entraînant la rotation des disques d'entraînement soumis au champ magnétique.

L'entraînement magnétique permet de réduire au minimum les contacts mécaniques générateurs de pollution.

Dans un mode de réalisation préféré, le moyen pour créer un champ magnétique est constitué d'au moins un aimant ayant un entrefer apte au passage sans contact des extrémités des disques d'entraînement.

De façon avantageuse, le moyen pour créer un champ magnétique est constitué d'aimants disposés sur une fraction de couronne entourant l'élément rotatif ayant chacun un entrefer apte au passage sans contact des extrémités des disques d'entraînement.

Le nombre des aimants est déterminé de telle façon que l'impulsion fournie aux disques d'entraînement en matériau conducteur soit suffisante pour que les échantillons soient présentés sous le faisceau d'ions avec des angles différents à chaque tour de tambour.

Cette réalisation permet de mettre les supports en rotation quasi continue sans mise en place d'amenée supplémentaire d'énergie. En effet, on utilise l'énergie cinétique de rotation du tambour pour mettre en mouvement les supports.

De plus, les chocs et frottements éventuels entre les pièces mécaniques sont limités au maximum de manière à éviter toute pollution des échantillons.

Un tel dispositif peut fonctionner sans problème aux températures atteintes dans la chambre contenant les échantillons ou plaquettes semiconductrices (ces températures peuvent atteindre 700 degrés Celsius) .

Selon les modes de réalisation, le disque d'entraînement peut prendre différentes formes. Il peut être plat, sensiblement conique ou encore bombé.

Selon un mode préféré de réalisation, les disques d'entraînement sont complètement réalisés en matériau sensible à un champ magnétique.

Selon un mode de réalisation particulier, les disques d'entraînement sont en matériau conducteur.

Selon un autre mode de réalisation particulier, les disques d'entraînement sont en matériau magnétique fritté.

Selon un autre mode de réalisation, les disques d'entraînement sont munis de moyens d'entraînement en matériau sensible à un champ magnétique. Ces moyens peuvent être par exemple une couronne en matériau magnétique fritté rapportée sur la circonférence de chaque disque.

Avantageusement, chaque disque d'entraînement est munie de moyens de positionnement sélectif de manière que le disque d'entraînement possède des positions angulaires privilégiées.

Selon un mode de réalisation particulier, ces moyens de positionnement sélectif comportent :
une pièce en matériau aimanté fixe,
au moins un pion apte à être aimanté et fixé sur le disque d'entraînement de manière à se trouver en regard du matériau aimanté lors de la rotation du disque d'entraînement.

De manière préférée, plusieurs pions sont répartis sur un cercle centré sur le centre du disque d'entraînement de manière à freiner la rotation du disque lors de leur passage devant le matériau aimanté. Le choix de la position des pions permet d'éviter que la plaquette de silicium ne se présente sous le faisceau d'ions suivant certains angles lors de la rotation du support. On réduit ainsi les problèmes liés à la canalisation des ions dans le monocristal de silicium.

Les caractéristiques et avantages de l'invention apparaîtront mieux à la lecture de la description qui suit donnée à titre illustratif et nullement limitatif en référence aux dessins annexés sur lesquels :
- la figure 1, déjà décrite et relative à l'art antérieur, représente schématiquement une vue partielle d'un dispositif pour l'implantation d'ions à la surface d'échantillons plans ;
- les figures 2a et 2b représentent schématiquement une vue en coupe (fig.2a) et de dessus (fig.2b) d'un dispositif conforme à l'invention ;
- la figure 3 représente schématiquement une variante de réalisation d'un disque d'entraînement conforme à l'invention,
- la figure 4 représente schématiquement les courants et les forces mis en jeu dans un système d'entraînement magnétique conforme à l'invention ;
- la figure 5 représente schématiquement une vue partielle en coupe d'un dispositif conforme à l'invention.

En référence aux figures 2a et 2b, on voit que l'élément rotatif 14, ici un tambour, d'un dispositif pour l'implantation d'ions du type de celui précédemment décrit est muni, conformément à l'invention, de moyens pour mettre en rotation les supports 12. Ces moyens sont constitués d'une part, par un moyen 18 pour créer un champ magnétique entourant une partie du tambour 14 et d'autre part, par des disques 22 en matériau sensible à un champ magnétique : matériau conducteur et amagnétique, par exemple en aluminium ou bien magnétique fritté. Ces disques sont solidaires des supports 12 et disposés à l'extérieur du tambour 14 de manière à ce qu'une extrémité de chaque disque baigne dans le champ magnétique, préférentiellement perpendiculairement à ce dernier.

Comme on peut encore le voir sur les figures 2a et 2b, le champ magnétique est créé entre les entrefers d'aimants 20 disposés en couronne autour d'une partie du tambour 14.

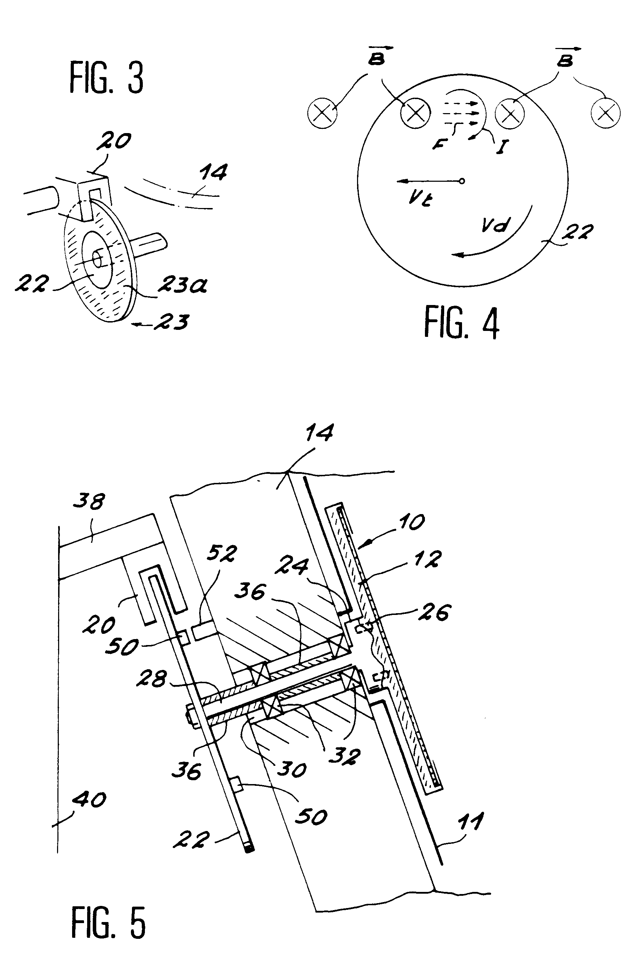

Sur la figure 3, on peut voir une variante de réalisation d'un disque d'entraînement 22. Ce dernier est en matériau amagnétique et comporte sur sa périphérie des moyens d'entraînement 23 en matériau sensible à un champ magnétique. Ces moyens comportent par exemple une couronne 23a en matériau magnétique fritté. Cette couronne 23a est telle qu'elle baigne dans le champ magnétique lors de la rotation du tambour.

L'entraînement en rotation des disques conducteurs 22 va maintenant être commenté en référence à la figure 4.

On voit sur la figure 4 un disque 22 entraîné par le tambour 14 (non représenté) dans un mouvement de rotation autour de l'axe du tambour avec une vitesse symbolisée par une flèche référencée Vt.

L'extrémité supérieure du disque 22 est plongée dans la distribution de champ magnétique 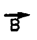 et est toujours sensiblement perpendiculaire à ce champ lors de la rotation du tambour 14.

On sait que, dans ces conditions, des courants de Foucault symbolisés par une flèche référencée I induisent un champ de force symbolisé par une flèche en trait tireté référencée F qui s'oppose au mouvement du disque 22 autour de l'axe de rotation du tambour et qui entraîne donc, par réaction, le disque 22 en rotation autour de son axe propre. Ce mouvement est symbolisé par une flèche référencée Vd. Chaque disque 22 étant solidaire d'un support 12, ces derniers sont donc entraînés en rotation autour des axes des disques 22.

La figure 5 représente schématiquement une vue partielle et en coupe d'un dispositif conforme à l'invention. Cette figure explicite le système de mise en rotation lié à chaque support.

Un échantillon plan 10 est disposé sur un support 12. Cet échantillon est usuellement une plaquette de silicium de 75 à 200 mm de diamètre et de 300 à 800 micromètres d'épaisseur. Le support 12 présente des dimensions adaptées à l'échantillon 10. Il est par exemple en quartz ou en tout autre matériau résistant à des températures de l'ordre de 300 à 700 degrés Celsius, ne contaminant pas l'échantillon et résistant au bombardement d'ions. Il peut avoir la forme d'un disque évidé, de croisillon ou tout autre forme adaptée au maintien de l'échantillon lors des rotations.

Le support 12 est fixé sur une pièce intermédiaire 24, par exemple en aluminium ou en inox. Il est centré sur cette pièce 24 par des pions 26 par exemple en aluminium ou en inox ou en quartz ou en un autre matériau résistant à la température ne contaminant pas l'échantillon.

Un axe 28 traverse le tambour 14 de part en part, perpendiculairement à ce dernier. En son extrémité intérieure au tambour 14, il est solidaire d'une pièce intermédiaire 24. En son autre extrémité extérieure au tambour 14, il est fixé au centre d'un disque d'entraînement 22.

L'axe 28 traverse le tambour 14 par une ouverture 30 aménagée à cet effet. Il est maintenu fixé au tambour 14 par une paire de roulements à billes 32 ou tout autre moyen de fixation adéquat. Une entretoise 36 assure la répartition des éléments liés à l'axe 28.

L'axe 28 est par exemple en inox ou en tout autre matériau assurant la rigidité de l'ensemble tournant (support et disque) et résistant à la chaleur et à l'oxydation.

Comme on l'a vu précédemment, le disque d'entraînement 22, parce qu'il a une extrémité plongée dans un champ magnétique adéquat, assure le mouvement de rotation qui est transmis au support 12 par l'intermédiaire de l'axe 28.

Le disque présente un diamètre qui résulte d'un compromis entre l'encombrement, le poids et le couple obtenu, par exemple 100 mm. Il possède une épaisseur de 2 mm, par exemple.

Sur l'exemple de la figure 5, le disque d'entraînement est plat.

Une extrémité du disque 22 est plongée dans le champ magnétique de direction perpendiculaire au plan du disque créé à l'intérieur de l'entrefer d'un aimant 20 en forme de U par exemple. L'entrefer (entre les branches du U de l'aimant) présente un espacement suffisant pour permettre le passage du disque d'entraînement 22 et éviter tout contact métallique avec celui-ci lors des rotations autour de l'axe de rotation du tambour et de l'axe 28. L'aimant 20 peut être permanent ou bien un électroaimant.

D'autres aimants 20 (non visibles sur la figure 4) sont répartis sur une partie du tambour 14 de manière à ce que le disque 22 possède un mouvement de rotation autour de l'axe 28 quasi continu.

A titre indicatif, 16 aimants espacés entre-eux de 3 mm sont répartis sur une partie de la couronne autour d'un tambour de 1 m de diamètre environ.

Dans l'exemple représenté figure 5, chaque aimant 20 est supporté par une patte 38 fixée sur la paroi 40 de la chambre dans laquelle est installé le tambour 14. Cette patte est par exemple en alliage d'aluminium ; elle permet de positionner les aimants de manière à créer une distribution de champ magnétique de direction perpendiculaire au plan du disque d'entraînement 22.

Le disque 22 représenté sur la figure 5 est muni de moyens de positionnement sélectif qui réduisent l'effet de canalisation en minimisant le temps d'exposition sous certains angles.

Ces moyens de positionnement sélectif comporte d'une part, un aimant 52 fixé sur le tambour 14 et d'autre part, des pions 50 fixés sur le disque 22 et en matériau sensible à un champ magnétique, en acier doux par exemple. Ces pions 50 par exemple au nombre de 8,sont répartis sur un cercle centré sur le centre du disque 22 et positionnés de manière à être en regard de l'aimant 52 lors de la rotation du disque 22.

Le système possède alors des angles de positions privilégiés correspondant à un pion 50 face à un pôle de l'aimant 52.

La mise en rotation de l'échantillon permet d'obtenir une répartition uniforme des ions et d'éviter les problèmes de canalisation. Un dispositif conforme à l'invention est économique et non polluant : l'entraînement en rotation est magnétique et utilise l'énergie de rotation du tambour.

Le dispositif conforme à l'invention est simple, rapidement démontable et remontable, ce qui facilite les nettoyages réguliers des éléments de la chambre d'implantation.

Bien entendu, cette invention ne reste pas limitée à la réalisation d'un dispositif comportant un tambour, mais est étendue à tout dispositif comportant un élément rotatif de forme choisie parmi les cônes, disques, pyramides, cylindres ou plaques portant les plaquettes semiconductrices à traiter.

## Revendications

1. Dispositif pour rendre homogène l'implantation d'ions sur la surface d'échantillons (10) plans comprenant un élément rotatif (14) et des supports (12) d'échantillons répartis sur une face de l'élément rotatif (14), les supports (12) d'échantillons étant maintenus à des premières extrémités d'axes (28) de rotation traversant l'élément rotatif (14), les secondes extrémités desdits axes étant soumis à des moyens de mise en rotation des supports, caractérisé en ce que les moyens de mise en rotation des supports comprennent un moyen (18) pour créer un champ magnétique et un disque d'entraînement (22) sensible à un champ magnétique maintenu à chaque seconde extrémité desdits axes, une extrémité de chacun des disques d'entraînement (22) étant plongée dans ledit champ magnétique lors de la rotation dudit élément rotatif (14), la rotation de l'élément rotatif (14) entraînant la rotation des disques d'entraînement (22) soumis au champ magnétique.

2. Dispositif selon la revendication 1, caractérisé en ce que le moyen (18) pour créer un champ magnétique est constitué d'au moins un aimant (20) ayant un entrefer apte au passage sans contact des extrémités des disques d'entraînement (22).

3. Dispositif selon la revendication 1, caractérisé en ce que les disques d'entraînement (22) sont complètement réalisés en matériau sensible à un champ magnétique.

4. Dispositif selon la revendication 3, caractérisé en ce que les disques d'entraînement (22) sont en matériau conducteur.

5. Dispositif selon la revendication 3, caractérisé en ce que les disques d'entraînement (22) sont en matériau magnétique fritté.

6. Dispositif selon la revendication 1, caractérisé en ce que les disques d'entraînement (22) sont munis de moyens d'entraînement (23) en matériau sensible à un champ magnétique.

7. Dispositif selon la revendication 1, caractérisé en ce que chaque disque d'entraînement (22) est muni de moyens de positionnement sélectif (50, 52) de manière que le disque d'entraînement (22) possède des positions angulaires privilégiées.

8. Dispositif selon la revendication 7, caractérisé en ce que les moyens de positionnement sélectif comportent :
une pièce (52) en matériau aimanté fixe,
au moins un pion (50) apte à être aimanté et fixé sur le disque d'entraînement (22) de manière à se trouver en regard de la pièce (52) en matériau aimanté lors de la rotation du disque d'entraînement (22).

## Patentansprüche

1. Vorrichtung zur Homogenisierung der Ionenimplantation auf der Oberfläche von ebenen Proben (10), die ein drehbares Element (14) und über eine Seite des drehbaren Elements (14) verteilte Probenhalterungen (12) umfaßt, wobei die Probenhalterungen (12) an ersten Enden von Drehachsen (28) gehalten sind, die das drehbare Element (14) durchqueren, die zweiten Enden der genannten Achsen Einrichtungen zur Drehung der Halterungen ausgesetzt sind, **dadurch gekennzeichnet**, daß die Einrichtungen zur Drehung der Halterungen umfassen eine Einrichtung (18), um ein Magnetfeld zu erzeugen, und eine Antriebsscheibe (22), die auf ein Magnetfeld anspricht, das an jedem zweiten Ende der genannten Achsen aufrechterhalten wird, wobei ein Ende jeder der Antriebsscheiben (22) in das genannte Magentfeld bei der Drehung des genannten drehbaren Elements (14) eingetaucht ist, die Drehung des drehbaren Elements (14) die Drehung der Antriebsscheiben (22) antreibt, die dem Magnetfeld ausgesetzt sind.

2. Vorrichtung gemäß dem Anspruch 1, **dadurch gekennzeichnet**, daß die Einrichtung (18), um ein Magnetfeld zu erzeugen, von wenigstens einem Magnet (20) gebildet ist, der einen für den berührungsfreien Durchgang der Enden der Antriebsscheiben (22) geeigneten Luftspalt hat.

3. Vorrichtung gemäß dem Anspruch 1, **dadurch gekennzeichnet**, daß die Antriebsscheiben (22) vollständig aus einem auf ein Magnetfeld ansprechenden Material hergestellt sind.

4. Vorrichtung gemäß dem Anspruch 3, **dadurch gekennzeichnet**, daß die Antriebsscheiben (22) aus einem leitenden Material sind.

5. Vorrichtung gemäß dem Anspruch 3, **dadurch gekennzeichnet**, daß die Antriebsscheiben (22) aus einem gesinterten, magnetischen Material sind.

6. Vorrichtung gemäß dem Anspruch 1, **dadurch gekennzeichnet**, daß die Antriebsscheiben (22) mit Antriebseinrichtungen (23) aus einem auf ein Magnetfeld ansprechenden Material versehen sind.

7. Vorrichtung gemäß dem Anspruch 1, **dadurch gekennzeichnet**, daß jede Antriebsscheibe (22) mit wahlweisen Positionierungseinrichtungen (50,52) derart versehen ist, daß die Antriebsscheibe (22) bevorzugte Winkelpositionen besitzt.

8. Vorrichtung gemäß dem Anspruch 7, **dadurch gekennzeichnet**, daß die wahlweisen Positionierungseinrichtungen umfassen:
ein festes Teil (52) aus einem magnetisierten Material,
wenigstens einen Zapfen (50), der magnetisiert werden kann und an der Antriebsscheibe (22) derart befestigt ist, daß er sich dem Teil (52) aus magnetisiertem Material bei der Drehung der Antriebsscheibe (22) gegenüber befindet.

## Claims

1. Apparatus for making homogeneous the implantation of ions on the surface of planar samples (10) comprising a rotary member (14) and sample supports (12) distributed over one face of the rotary member (14), the sample supports (12) being maintained at first ends of rotation spindles (28) traversing the rotary member (14), the second ends of said spindles being subject to the action of means for rotating the supports, characterized in that the means for rotating the supports comprise a means (18) for creating a magnetic field and a drive disk (22) sensitive to a magnetic field maintained at each second end of said spindles, one end of each of the drive disks (22) being immersed in said magnetic field during the rotation of said rotary member (14), the rotation of the rotary member (14) bringing about the rotation of the drive disks (22) subject to the action of the magnetic field.

2. Apparatus according to claim 1, characterized in that the means (18) for creating a magnetic field is constituted by at least one magnet (20) having an air gap suitable for the contact-free passage of the ends of the drive disks (22).

3. Apparatus according to claim 1, characterized in that the drive disks (22) are made from a material sensitive to a magnetic field.

4. Apparatus according to claim 3, characterized in that the drive disks (22) are made from a conductive material.

5. Apparatus according to claim 3, characterized in that the drive disks (22) are made from a sintered magnetic material.

6. Apparatus according to claim 1, characterized in that the drive disks (22) are provided with drive means (23) made from a material sensitive to a magnetic field.

7. Apparatus according to claim 1, characterized in that each drive disk (22) is provided with selective positioning means (50, 52), so that the drive disk (22) has privileged angular positions.

8. Apparatus according to claim 7, characterized in that the selective positioning means incorporate a fixed magnetized material part (52) and at least one pin (50) which can be magnetized and fixed to the drive disk (22), so that it is positioned facing the magnetized material part (52) during the rotation of the drive disk (22).
